Europäisches Patentamt

European Patent Office

Office européen des brevets

(11) Numéro de publication: **0 100 726**
A1

# (12) DEMANDE DE BREVET EUROPEEN

(21) Numéro de dépôt: 83401541.4

(22) Date de dépôt: 27.07.83

(51) Int. Cl.³: **D 21 H 5/00**
**H 05 K 9/00**

(30) Priorité: 30.07.82 FR 8213392

(43) Date de publication de la demande:
15.02.84 Bulletin 84/7

(84) Etats contractants désignés:
AT BE CH DE GB IT LI LU NL SE

(71) Demandeur: ARJOMARI-PRIOUX Société anonyme dite
3, rue du Pont de Lodi
F-75261 Paris Cedex 06(FR)

(72) Inventeur: Vallee, Antoine
Favetière
F-38850 Charavines(FR)

(72) Inventeur: Goguelin, Michel
"Le Guillermet"
F-38850 Charavines(FR)

(74) Mandataire: Richebourg, Michel François et al,
Cabinet Beau de Loménie 55, rue d'Amsterdam
F-75008 Paris(FR)

(54) **Feuilles papetières contenant des fibres métalliques, leur fabrication et leurs applications à la protection - ou blindage - contre les interférences électromagnétiques.**

㊗ Des feuilles (1) obtenues par voie papetière et contenant essentiellement une faible proportion des fibres métalliques, une phase thermoplastique (en pâte et/ou poudre et/ou latex) et éventuellement de la cellulose.

La proportion préférée de fibres métalliques est d'environ 0,5-3,5% en poids/mélange total.

Application à la fabrication de plaques et boîtiers blindes, p.ex. sous forme de structure composite associant des feuilles conductrices (1) et des feuilles neutres (2) ne comportant pas de fibres métalliques.

Fig. 1

EP 0 100 726 A1

Croydon Printing Company Ltd

<u>Feuilles papetières contenant des fibres métalliques, leur fabrication et leurs applications à la protection - ou blindage- contre les interférences électromagnétiques.</u>

La présente invention concerne un nouveau matériau obtenu par voie papetière contenant des fibres métalliques, et pouvant donner par moulage ou thermoformage des articles tels que boitiers de calculatrices, éléments d'ordinateurs, etc. protégeant l'environnement ou les circuits de l'appareil contre les interférences électromagnétiques émises ou reçues.

Dans ce domaine, on connaissait déjà les matières plastiques modifiées par des poudres, des "flocons", etc. métalliques, qui ne relèvent pas du domaine de l'obtention par voie papetière.

On a également tenté d'incorporer des fibres métalliques dans des mélanges thermoplastiques ou thermodurcissables par des procédés tels que l'injection de granulés extrudés, le moulage au contact ou le moulage par compression.

Dans toutes les techniques connues, on n'obtient pas de blindage efficace si la teneur en fibres métalliques est inférieure à environ 6 % en poids par rapport au "mélange total" (c'est-à-dire conduisant au produit fini).

Dans ces techniques, on est obligé d'incorporer en général de 6 à 8 % de fibres métalliques, ce qui entraîne une élévation prohibitive du coût.

Avec le développement des techniques liées à l'informatique, on a donc cherché depuis déjà un certain temps, sans y parvenir, à abaisser le taux de fibres métalliques tout en conservant un blindage efficace.

Il a maintenant été découvert selon l'invention que, par voie papetière, il est possible d'obtenir une feuille thermoplastique contenant une faible proportion de fibres métalliques, d'environ 0,5 à environ 3,5 % en poids/mélange total, et capable de donner par moulage-estampage de préférence, mais aussi par injection-moulage des articles présentant des propriétés mécaniques satisfaisantes et capables de réaliser un blindage électromagnétique tout à fait efficace.

Compte tenu du faible taux de fibres métalliques, cette dernière propriété est surprenante, car on sait que l'effet de blindage est dû à l'existence ou à la formation d'un "treillis" métallique qui doit être suffisamment dense, et que l'on ne pensait pas pouvoir obtenir avec si peu de fibres métalliques.

Les compositions selon l'invention, permettant d'obtenir directement par voie papetière les feuilles thermoplastiques décrites ci-dessus, contiennent les composants suivants (% en poids par rapport au mélange total) :

- fibres métalliques : 0,5 - 3,5 % de préférence environ 2 % ;

- au moins un élément thermoplastique (pâte et/ou poudre thermoplastique) ; dans le cas d'une pâte, la composition pourra passer directement sur machine à papier, tandis que dans le cas d'une poudre il sera nécessaire d'utiliser un élément de cohésion papetière c'est-à-dire :

. un système liant (latex + floculant)

. et/ou de la pâte de cellulose ;

la poudre pourra également être formée in situ par précipitation d'un latex.

- éventuellement : agents de renforcement du produit fini, notamment fibres de verre, charges minérales comme le talc,...

- éventuellement les adjuvants classiques.

/ L'élément thermoplastique doit représenter au total au moins environ 50 % du poids du mélange total/

Ainsi, les compositions suivantes :

- fibres métalliques : 0,5 - 3,5 %

- élément thermoplastique (en pâte) : 99,5 - 96,5 % font partie de l'invention.

On pourra utiliser des fibres métalliques de longueur 3 à 10 mm environ, et de diamètre 2 à 10 μ environ.

En ce qui concerne les divers composants utilisables, l'homme du métier pourra se référer aux demandes de brevets français n° 79 17910 déposée le 10 juillet 1979 et 80 09858 déposée le 30 avril 1980.

Ainsi, par conséquent :

- les pâtes et poudres de polyoléfines utilisables, seront choisies en particulier parmi les polyéthylènes et polypropylènes, leurs copolymères et leurs dérivés.

Comme autres substances thermoplastiques, on pourra utiliser des résines en poudre telles que polyoxyphénylènes modifiés, notamment le produit "NORYL", polyamides, copolymères acrylonitrile-butadiène-styrène (ABS), ou polycarbonates ;

- on pourra utiliser les charges minérales classiques dans l'industrie des plastiques ; talc, mica, silice, fibres de verre broyées, bille de verre ;

- les fibres de verre pourront présenter une longueur de 2 à 15 mm environ, et un diamètre de 2 à 15 μ environ ;

- on pourra incorporer les adjuvants classiques : pigments antioxydants, ...

De préférence, les fibres cellulosiques que l'on peut éventuellement introduire présenteront un degré de raffinage de 40 à 55° Schopper environ.

On préférera utiliser des fibres cellulosiques dans le mélange car cela facilite grandement le passage sur la machine à papier et renforce le produit fini.

Dans les produits selon l'invention, on notera que les fibres métalliques ont un rôle de renforcement tout à fait négligeable en raison de leur présence en faible proportion.

Enfin, le taux de fibres métalliques pourra être supérieur à 3,5 % environ. Cependant, il ne sera pas intéressant en pratique industrielle de dépasser cette limite car le gain en blindage n'est pas justifié, sauf cas particuliers, par l'augmentation du coût du produit.

De préférence, la teneur en fibres métalliques se situera autour de 2 %.

Un mode opératoire qui a donné de bons résultats est le suivant.

On réalise une dispersion des fibres de verre éventuelles à l'aide du dispersant (produit cationique à base d'acide gras, de préférence), à laquelle on ajoute les fibres métalliques, et on forme une nouvelle dispersion.

On ajoute à cette dispersion éventuellement la pâte de polyoléfine(s), éventuellement la pâte de cellulose, puis éventuellement les poudres minérales ou thermoplastiques ; puis on additionne ensuite (en continu ou non) des adjuvants classiques comme un agent anti-mousse, puis éventuellement le latex, et enfin éventuellement le floculant de tête.

Le passage sur machine à papier, d'une manière connue, donne la feuille décrite plus haut.

Dans ce domaine également, l'homme de métier pourra se référer à la demande de brevet français n° 80 09858 déposée le 30 avril 1980.

On trouvera ci-dessous des exemples non limitatifs de compositions selon l'invention et d'applications des feuilles obtenues à partir de ces compositions.

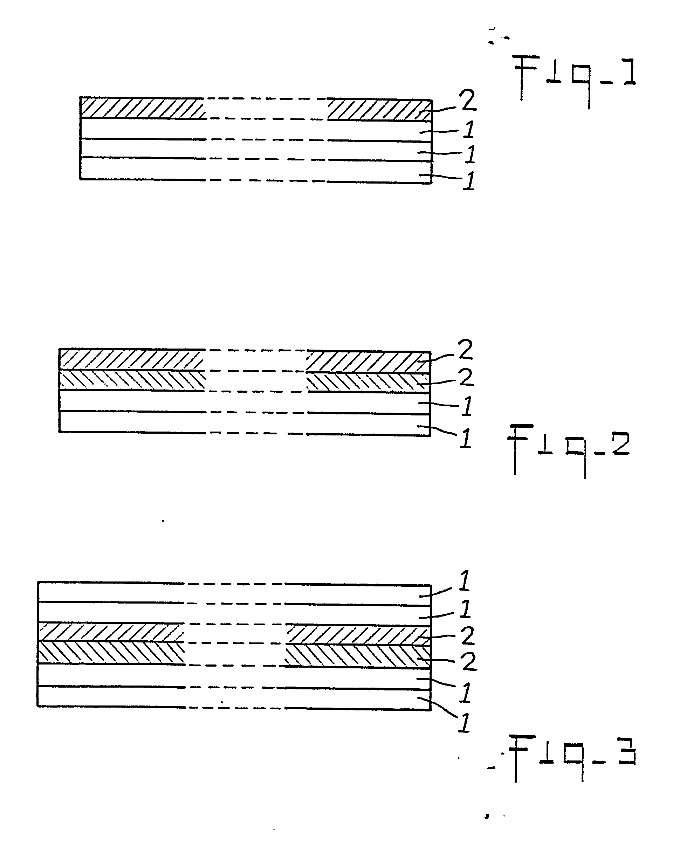

Les figures 1, 2 et 3 représentent en coupe des structures composites associant des feuilles conductrices selon l'invention (1) et neutres (2), sur lesquelles des essais ont également été effectués.

Dans les essais qui sont relatés ci-après, on a apprécié l'efficacité de blindage SE = 10 log P/Po (en décibels, où Po et P sont respectivement les énergies reçues et transmises) par la réflexion à 10 GHz (R) et la résistivité spécifique du matériau ($\rho$).

On sait en effet que l'efficacité de blindage dans les conditions de mesure données (longueur d'onde, géométrie ...) dépend essentiellement d'une composante absorption, fonction de l'épaisseur du matériau et reliable à $\rho$, et d'un facteur réflexion indépendant de l'épaisseur mais aussi reliable à $\rho$. Il est admis que, quelle que soit la longueur d'onde, 99% des problèmes de blindage sont résolus si SE est au moins égale à 35 dB à 1000 MHz et, pour un produit d'épaisseur 3 mm, on considère ainsi la caractéristique de blindage comme excellente lorsque R > 85% et correcte si R ⩾ 65% environ, 65% représentant donc la limite inférieure admissible, ou lorsque la résistivité spécifique $\rho$ est inférieure à 5 $\Omega$ cm environ.

Les compositions selon l'invention ayant fait l'objet des essais sont indiquées dans les tableaux I à V ci-après.

Le tableau VI regroupe à titre comparatif des compositions avec poudre ou fibres de carbone dont l'emploi papetier est déjà connu et qui

. à faible taux ne permettent pas d'atteindre le niveau recherché de blindage

. interdisent toute coloration dans la masse

Les résultats obtenus sont rassemblés dans le tableau VII ci-après.

Le passage des compositions sur machine à papier donne une feuille thermoplastique telle que décrite plus haut (cf. demandes de brevets précitées, pour les détails essentiels du procédé de fabrication).

Pour les essais de moulage-estampage, on a empilé un certain nombre de ces feuilles, on a chauffé et comprimé l'ensemble (pour le mode opératoire, on pourra se reporter à la demande de brevet précitée n° 80 09858 déposée le 30 avril 1980, notamment exemple 1, page 7) et on a ainsi fabriqué :

- soit des plaques d'épaisseur 3 mm;

- soit des boîtiers d'épaisseurs de parois 6 mm (essai 16844) ou 3 mm (essais 16941, 16942). Les essais ont été menés sur toutes les faces et ont démontré l'homogénéité des valeurs obtenues, et donc l'existence d'une répartition uniforme des fibres : ainsi, contrairement à ce que l'on obtient par exemple par une technique par injection, l'estampage des matériaux de l'invention permet d'obtenir des produits exempts de "points faibles".

On a aussi stratifié des plaques complexes telles que représentées en coupe sur les figures 1, 2 et 3. Pour la fabrication de ces complexes, les feuilles conductrices (1) utilisées sont celles correspondant à la composition 16845, et les feuilles neutres (2) sont identiques, sauf en ce qu'elles ne comportent pas de fibres métalliques (mais elles présentent le même grammage que les feuilles conductrices). Chaque feuille initiale présente un grammage de l'ordre de 500 g/m$^2$.

Résultats :

- complexe selon figure 1 : R = 85%

- complexe selon figure 2 : R = 89%

- complexe selon figure 3 : R = 87% (valeurs moyennes sur 3 essais)

6

**0100726**

Ces complexes sont très intéressants du fait que, pour beaucoup d'applications, une efficacité SE de 20 dB à 1000 MHz est suffisante; or, on a pu déterminer sur un échantillon du type de la figure 1, mais avec l'essai 16941 (600 $g/m^2$), une valeur de 21 dB par mesure directe (type Shielded room (box)-test).

Pour les essais d'injection, la feuille d'ABS est préalablement mise en fines bandes ou pastilles, en pseudo-granulés (8 x 8 x 2 mm) qui sont introduits dans une presse à injecter (corps de chauffe entre 200 et 240°C) et moulés en une plaque d'épaisseur 3 mm. Les résultats de blindage, bien que très inférieurs à ceux obtenus sur pièces estampées ou plaques stratifiées, demeurent néanmoins, grâce au respect de l'intégrité des fibres métalliques lors de la dispersion papetière, bien supérieurs à ceux qui peuvent être obtenus par injection de granulés extrudés de même taux de fibres métalliques.

## T A B L E A U   I

ESSAI   n° 16417

| | |
|---|---|
| Dispersant cationique DS 1 (+) | 10 |
| Fibres de verre (1 = 3 mm) (∅ 11 μ) | <u>40</u> |
| Fibres métalliques (8 μ ; 5 mm) (++) | 5 |
| Pâte de polyéthylène (++) | 20 (indice de fluidité 5) |
| Poudre de polypropylène | <u>60</u> (indice de fluidité 8) (granulométrie 80 μ) |
| Agent anti-mousse (++) | 0,5 |
| Latex (x) (sec) | 10 |
| Floculant de tête (polyacrylamide cationique) (sec) | 0,2 %/reste du mélange, en poids |
| % fibres métalliques/mélange total | 3,7 |

Valeurs soulignées : mélange de base

(++) en  %/mélange de base, en poids

(+) en  %/fibres de verre, en poids

(x) polymère renfermant 40 à 50 parties en poids de motifs styrène, 25 à 30 parties en poids de motifs butadiène, 2 à 7 parties en poids d'acide carboxylique, et le solde en motifs acrylate de butyle. (dispersion aqueuse à 50 %).

TABLEAU II
----------------

| ESSAIS N° | 16843 | 16844 | 16845 |
|---|---|---|---|
| Dispersant cationique (+) | 10 | 10 | 10 |
| Fibres de verre (1 = 3mm) ($\emptyset$ 11 $\mu$) | 35 | 35 | 35 |
| Fibres métalliques (++) | 5 (a) | (a) 3 | (a) 1,5 |
| Pâte de polyéthylène (++) | 20 | 20 | 20 |
| Fibres cellulosiques (50° SR) (++) | 10 | 10 | 10 |
| Talc | 15 | 15 | 15 |
| Poudre de polypropylène | 50 | 50 | 50 |
| Colorant (noir Elflex) (++) | 1 | 1 | 1 |
| Agent anti-mousse (++) | 0,5 | 0,5 | 0,5 |
| Latex (x) (sec) (++) | 10 | 10 | 10 |
| Floculant de tête (xx) (sec) | 0,2 | 0,2 | 0,2 %/reste de la composition,en poids |
| % fibres métalliques par rapport au mélange total : | 3,5 | 2,1 | 1,1 |

(++) cf. Tableau I
(+) cf. Tableau I
(x) cf. Tableau I
(a) 8 $\mu$ ; 5 mm

(b) 4 $\mu$ ; 6 mm
(xx) polyacrylamide cationique.
- Pâte de polyéthylène : indice de fluidité 5
- Poudre de polypropylène : indice de fluidité 8; granulométrie 80 $\mu$

TABLEAU II (suite 1)

| ESSAIS N° | 16846 | 16847 | 16848 |
|---|---|---|---|
| Dispersant cationique (+) | 10 | 10 | 10 |
| Fibres de verre (1 = 3mm) (Ø 11 $\mu$) | 35 | 35 | 35 |
| Fibres métalliques (++) | (b) 5 | (b) 3 | (b) 1,5 |
| Pâte de polyéthylène (++) | 20 | 20 | 20 |
| Fibres cellulosiques (50° SR) (++) | 10 | 10 | 10 |
| Talc | 15 | 15 | 15 |
| Poudre de polypropylène | 50 | 50 | 50 |
| Colorant (noir Elflex) (++) | 1 | 1 | 1 |
| Agent anti-mousse (++) | 0,5 | 0,5 | 0,5 |
| Latex (x) (sec) (++) | 10 | 10 | 10 |
| Floculant de tête (xx) (sec) | 0,2 | 0,2 | 0,2 % |
| % fibres métalliques par rapport au mélange total | 3,5 | 2,1 | 1,1 |

(++) cf. Tableau I  
(+) cf. Tableau I  
(x) cf. Tableau I  
(a) 8 $\mu$ ; 5 mm

(b) 4 $\mu$ ; 6 mm  
(xx) polyacrylamide cationique.  
-Pâte de polyéthylène : indice de fluidité 5  
-Poudre de polypropylène : indice de fluidité 8 ; granulométrie 80 $\mu$

T A B L E A U    III
-----------------------

ESSAI

16941

|  |  |
|---|---|
| Dispersant cationique (+) | 10 |
| Fibres de verre (3mm) (Ø 11 μ) | 20 |
| Fibres métalliques (8 μ ; 5 mm) (++) | 2 |
| Pâte de polyéthylène | 72 |
| Fibres cellulosiques (50° SR) | 8 |
| Colorant (Noir Elflex) (++) | 0,5 |
| % fibres métalliques/mélange total | 2/102 = 1,96 |

Pâte de polyéthylène : indice de fluidité 5

Valeurs soulignées : mélange de base

(+) cf. Tableau I

(++) cf. Tableau I

| E S S A I | 16942 |
|---|---|
| Dispersant (+) | 10 |
| Fibres de verre (3 mm) (Ø 11 $\mu$) | <u>28</u> |
| Fibres métalliques (8 $\mu$ ; 5 mm) (++) | 2,8 |
| Pâte de polyéthylène | <u>27</u> |
| Poudres de polypropylène ① | <u>45</u> |
| ② (++) | 5 |
| Fibres cellulosiques (50° SR) (++) | 10 |
| Talc (charge) (++) | 15 |
| Colorant Noir Elflex (++) | 0,7 |
| Agent anti-mousse (++) | 0,5 |
| Latex acrylique (o) (sec) (++) | 10 |
| Floculant de tête (sec) | 0,2%/reste de la composition, en poids |

% fibres métalliques par rapport au mélange total

$$\frac{2,8}{142,8} = 1,96$$

Valeurs soulignées : mélange de base

(+)  
(++)  } cf. Tableau I  
(xx)

Latex (o) : polymère renfermant 87 à 90 parties en poids de motifs acrylate d'éthyle, 1 à 8 parties en poids de motifs acrylonitrile, 1 à 6 parties en poids de motifs N-méthylol-acrylamide et 1 à 6 partie en poids de motifs acide acrylique.

Dispersion aqueuse à 50 %

Poudre ① : indice de fluidité 12 ; granulométrie 60 $\mu$
Poudre ② : indice de fluidité 8 ; granulométrie 80 $\mu$

TABLEAU V

| ESSAIS N° | 11959 | 11960 |
|---|---|---|
| Fibres cellulosiques (50° SR) | <u>10</u> | <u>10</u> |
| Poudre d'ABS | | <u>78</u> |
| Dispersant cationique (+) | | 10 |
| Fibres métalliques (8/u; 5 mm) | <u>2</u> | <u>2</u> |
| Floculant (xx) (++) (sec) | 0,25 | |
| Latex d'ABS préfloculé (xxx) (sec) | <u>88</u> | |
| Agent anti-mousse (++) | 0,2 | 0,1 |
| Latex (x) (sec) | | <u>10</u> |
| Floculant de tête (xx) (++) (sec) | 0,5 | 0,6 |
| % fibres métalliques par rapport au mélange total | 2 | 2 |

. valeurs soulignées = mélange de base

(+) en %/ABS, en poids

(++) en %/mélange de base, en poids

(x) polymère à base de styrène et d'ester acrylique (dispersion aqueuse à 50%)

(xx) polyacrylamide cationique

(xxx) latex d'ABS floculé à l'acide acétique avant introduction au mélange (dispersion aqueuse à 35%)

## TABLEAU VI

| ESSAIS N° | 16418 | 16419 | 16420 |
|---|---|---|---|
| Dispersant cationique (+) | 10 | 10 | 10 |
| Fibres de verre (3 mm) (Ø 11/u) | 40 | 40 | 40 |
| Fibres de carbone (5 mm) (++) | 1 | 5 | |
| Noir de carbone (++) | | | 10 |
| Pâte de polyéthylène (++) | 20 | 20 | 20 |
| Poudre de polypropylène | 60 | 60 | 60 |
| Agent anti-mousse (++) | 0,5 | 0,5 | 0,5 |
| Latex (x) (++) (sec) | 10 | 10 | 10 |
| Floculant de tête (xx) (sec) | 0,2 | 0,2 | 0,2% reste du mélange en poids |
| % éléments conducteurs par rapport au mélange total | 0,8 | 3,7 | 7,1 |

. valeurs soulignées = mélange de base

(+)  
(++)  
(x)  
(xx)  

} cf. tableau I

. mêmes pâte et poudre qu'au tableau I

TABLEAU VII

% par rapport au mélange total de :

| ESSAIS N° | fibres de carbone | fibres métalliques | noir de carbone | R (%) | $\rho$ ($\Omega$.cm) | Essai réalisé sur : |
|---|---|---|---|---|---|---|
| 16417 | | 3,7 | | 92 | 1 | . plaque estampée épaisseur 3 mm |
| 16843 | | 3,5 | | 95 | | . plaque " |
| 16844 | | 2,1 | | 82 | | boîtier épaisseur parois 6 mm |
| 16844 | | 2,1 | | $\triangle$ 92 | | plaque estampée |
| 16845 | | 1,1 | | 86 | | plaque " |
| 16846 (x) | | 3,5 | | 93 | | plaque " |
| 16847 | | 2,1 | | 92 | | plaque " |
| 16848 | | 1,1 | | $\triangle$ 86 | | plaque " |
| 16418 | 0,8 | | | 53 | $10^6$ | plaque " |
| 16419 | 3,7 | | | 82 | $10^2$ | plaque " |
| 16420 | | | 7,1 | 53 | $10^2$ | plaque " |
| 11959 et 11960 | | 2 | | 65 | | plaque injectée épaisseur 3 mm |
| 16941 | | 2 | | 88 | | boîtier épaisseur parois 3 mm |
| 16942 | | 2 | | 89 | | boîtier " |

(x) on obtient une dispersion moins bonne dans cet essai, probablement parce que le diamètre des fibres (4 $\mu$) est un peu trop faible compte tenu de leur longueur (6 mm).

N.B. Les taux de cendres, ou de charges après extraction de la résine, ne révèlent pas d'écarts significatifs dans le produit fini par rapport aux pourcentages initialement introduits.

15

0100726

REVENDICATIONS

1.      Feuilles papetières caractérisées en ce qu'on les obtient par passage sur machine à papier d'une composition comprenant :
- fibres métalliques  0,5 - 3,5 % en poids par rapport au mélange total ;
- au moins un élément thermoplastique choisi parmi les pâtes et/ou poudres thermoplastiques : au total au moins environ 50 % en poids par rapport au mélange total,
        . dans le cas d'une poudre ; un élément de cohésion papetière choisi parmi :
            + un système liant constitué d'un liant et d'un floculant
            + et/ou de la pâte de cellulose ;
- éventuellement : agents de renforcement du produit fini, notamment fibres de verre, charges minérales,...
- éventuellement les adjuvants classiques.

2.      Feuilles papetières selon la revendication 1 caractérisées en ce qu'elles contiennent environ 2 % de fibres métalliques par rapport au mélange total.

3.      Feuilles papetières selon la revendication 1 ou 2, caractérisées en ce que l'on utilise des fibres métalliques de longueur 3 à 10 mm environ et de diamètre 2 à 10 $\mu$ environ.

4.      Feuilles papetières selon l'une quelconque des revendications 1 à 3, caractérisées en ce que les fibres métalliques sont choisies parmi celles présentant les caractéristiques suivantes :
        . 1 = 3 mm diamètre 11 $\mu$
        . 1 = 5 mm diamètre  8 $\mu$
        . 1 = 6 mm diamètre  4 $\mu$

5.      Feuilles papetières selon l'une quelconque des revendications 1 à 4, caractérisées en ce que les éléments thermoplastiques sont choisis parmi les pâtes et poudres de polyoléfines, notamment pâte de polyéthylène, et/ou poudre de polypropylène, leurs copolymères et leurs dérivés.

6.      Feuilles papetières selon l'une quelconque des revendications 1 à 4, caractérisées en ce que les éléments thermoplastiques sont choisis parmi des résines en poudres telles que polyoxyphénylènes modifiés, polyamides, copolymères acrylonitrile-butadiène-styrène (ABS),polycarbonates.

7. Feuilles papetières selon l'une quelconque des revendications 1 à 6, caractérisées en ce que les charges minérales sont choisies parmi les suivantes : talc, mica, silice, fibres de verre broyées, billes de verre.

8. Feuilles papetières selon l'une quelconque des revendications 1 à 7, caractérisées en ce que les fibres de verre utilisées présentent une longueur de 2 à 15 mm environ et un diamètre de 2 à 15 μ environ.

9. Feuilles papetières selon l'une quelconque des revendications 1 à 8, caractérisées en ce qu'elles contiennent de la pâte de cellulose, les fibres cellulosiques étant raffinées à 40 - 55° Schopper environ.

10. Feuilles papetières selon l'une quelconque des revendications 1 à 9, caractérisées en ce que le liant est choisi parmi :
- les polymères renfermant de 40 à 50 parties en poids de motifs styrène, de 25 à 30 parties en poids de motifs butadiène, de 2 à 7 parties en poids d'acide carboxylique, et le solde en motifs acrylate de butyle ; et
- les polymères renfermant de 87 à 90 parties en poids de motifs acrylate d'éthyle, de 1 à 8 parties en poids de motifs acrylonitrile, de 1 à 6 parties en poids de motifs N-méthylolacrylamide et de 1 à 6 parties en poids de motifs acide acrylique.

11. Procédé de fabrication des feuilles selon l'une quelconque des revendications 1 à 10 caractérisé en ce que on réalise une dispersion des éventuelles fibres de verre à l'aide du dispersant, on ajoute les fibres métalliques, et on forme une nouvelle dispersion, on ajoute éventuellement la pâte de polyoléfine(s), éventuellement la pâte de cellulose, puis éventuellement les poudres minérales ou thermoplastiques, puis on additionne ensuite, en continu ou en discontinu, les adjuvants, puis éventuellement le latex, et éventuellement le floculant de tête, après quoi on fait passer classiquement sur machine à papier.

12.     Application des feuilles papetières selon l'une quelconque des revendications 1 à 10, après moulage-estampage, comme éléments de blindage contre les interférences électromagnétiques, par exemple boitiers de calculatrices, éléments d'ordinateur, et analogues.

Fig-1

2
1
1
1

Fig-2

2
2
1
1

Fig-3

1
1
2
2
1
1

Office européen
des brevets

**RAPPORT DE RECHERCHE EUROPEENNE**

Numéro de la demande

EP   83 40 1541

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X,Y | FR-A-2 425 937 (ARJOMARI-PRIOUX) <br><br> * Revendications 1,7-10,20; page 2, ligne 33 - page 4, ligne 2; page 14 * | 1,3,5 9,11, 12 | D 21 H   5/00 <br> H 05 K   9/00 |
| Y | FR-A-1 266 097 (KIMBERLY-CLARK) <br><br> * En entier * | 1,2,9 12 | |
| Y | GB-A-1 410 107 (MITSUBISHI SEISHI) <br> * En entier; en particulier page 6, lignes 46-49 * | 1,5,9 11,12 | |
| Y | EP-A-0 039 292 (ARJOMARI-PRIOUX) (revendiquant la priorité FR 8009858, citée dans le texte de la demande examinée) <br> * En entier * | 1,3,5- 8,10- 12 | **DOMAINES TECHNIQUES RECHERCHES (Int. Cl. 3)** <br><br> D 21 H <br> H 05 K |
| A | FR-A-2 454 450 (DART INDUSTRIES) <br> * En entier * | 12 | |
| A | FR-A-2 390 463 (IBM) <br> * En entier * | 12 | |

Le présent rapport de recherche a été établi pour toutes les revendications

| Lieu de la recherche | Date d'achèvement de la recherche | Examinateur |
|---|---|---|
| LA HAYE | 27-10-1983 | NESTBY K. |